# EUROPEAN PATENT SPECIFICATION

(11) **EP 3 970 524 B1**
(45) Date of publication and mention of the grant of the patent: **13.11.2024**
(21) Application number: 20805728.1
(22) Date of filing: 14.05.2020
(51) Int. Cl.: H05B 3/16, A24F 40/40, A24F 40/46, C04B 35/10

(54) **HEATING-AIR-TYPE E-CIGARETTE HEATER, CERAMIC HEATING BODY AND PREPARATION METHOD THEREFOR**
LUFTERWÄRMUNGSHEIZAGGREGAT FÜR E-ZIGARETTE, KERAMISCHER HEIZKÖRPER UND VERFAHREN ZU SEINER HERSTELLUNG
DISPOSITIF DE CHAUFFAGE DE CIGARETTE ÉLECTRONIQUE DE TYPE À CHAUFFAGE D'AIR, CORPS CÉRAMIQUE CHAUFFANT ET PROCÉDÉ DE PRÉPARATION CORRESPONDANT

(30) Priority: 16.05.2019 CN 201920703126 U; 16.05.2019 CN 201920703695 U; 16.05.2019 CN 201920707429 U; 16.05.2019 CN 201910409470
(43) Date of publication of application: 23.03.2022
(73) Proprietor: Xiamen Fengtao Ceramics Co., Ltd, Xiamen, Fujian 361000 (CN)
(72) Inventor: ZHU, Xiaohua, Xiamen, Fujian 361000 (CN); XIONG, Zhaorong, Xiamen, Fujian 361000 (CN); FU, Zengxue, Xiamen, Fujian 361000 (CN); YU, Xiangyi, Xiamen, Fujian 361000 (CN); LIU, Maoqi, Xiamen, Fujian 361000 (CN)
(74) Representative: Ipey
(86) International application number: PCT/CN2020/090241
(87) International publication number: WO 2020/228773

(56) References cited:
- EP-A1- 3 620 071
- WO-A1-2018/201561
- CN-A- 102 701 726
- CN-A- 104 703 308
- CN-A- 110 022 622
- CN-U- 207 444 282
- CN-U- 207 505 928
- CN-U- 207 505 928
- CN-U- 208 079 427
- CN-U- 208 338 876
- CN-U- 210 329 353
- CN-U- 210 329 363
- US-A1- 2015 359 262
- US-A1- 2018 064 170

## Description

### Technical field

The present invention relates to the technical field of heat not burn, in particular to a ceramic heating element, an air-heating type heat not burn heating device with the ceramic heating element, and a preparation method of the ceramic heating element.

### Background art

Tobaccos are burned to produce tobacco smoke when smoking products such as cigarettes and cigars are used. Smoke generated by tobacco burning contains many carcinogens like tar, which may do great harm to the human body in case of long-term inhalation. With the technological advancements, people have a pursuit for a healthy life. Therefore, heat not burn products are developed to replace the cigarettes. One of the typical heat not burn solutions is to provide an alternative to these types of products by producing products that release compounds without burning. One example of such products is the so-called heat not burn product, also known as a tobacco heating product or a tobacco heating device, which releases compounds by heating but not burning the material.

With regard to the heat not burn products currently available on the market, the heating and braking technology applied conducts heat transfer and exchange by way of heat transfer.

CN 208 079 427 U discloses a hot -blast formula pottery heating element component, wherein, ceramic heating element component has multiple compound mode: first kind of compound mode comprises ceramic heating tube, the pottery heating tube generates heat alone, second kind compound mode is generated heat excellent core by ceramic heating tube and pottery and is constituted, pottery heating tube and pottery generate heat excellent core and generate heat jointly, the tertium genus compound mode is generated heat excellent core by ceramic pipe and pottery and is constituted, the pottery generates heat excellent core and generates heat, and the ceramic pipe does not generate heat. The pottery generates heat excellent core and establishes inside ceramic heating tube or ceramic pipe, the ceramic pipe is inside vertically to be passed through a through-hole structure or vertically link up the honeycomb type cavernous structure for there are a plurality of vertical perforating holes and a vertical through circular holes in centre cylindrical structure or horizontal opening intercommunication in the centre. The beneficial effects of the utility model are that: it is efficient to generate heat, long service life, and stable in structure, safety ring protects.

CN 208 338 876 U discloses a ceramic heat -generating body for electron cigarette tobacco -baking equipment relates to electron cigarette accessory technical field, include the ceramic body that is the hollow shape of upper end open -ended, the inner wall fixedly connected with of ceramic body centres on ceramic body evenly distributes the piece that generates heat, and the both ends of the piece that generates heat are installed the lead wire respectively and are gone between and extend the ceramic body, and a plurality of inlet ports have been offered to the downside wall body of ceramic body, piece evenly distributed is at the inner wall of ceramic body owing to generate heat, consequently makes to generate heat the piece at the in -process that progressively generates heat, and heat transfer is to the outer ceramic body, and heat transfer is fast, ceramic inner wall through the ceramic body heats cigarette, can make the pipe tobacco in the cigarette be heated evenly, the constancy of temperature, greatly increased the taste and the stability of electronics cigarette flue -cured tobacco, the not direct contact pipe tobacco of piece owing to generate heat to can prolong the life of the piece that generates heat.

CN 207 505 928 U discloses a heating device and a smoking set. This heating device includes:
the chimney for it to accept the cigarette, the chimney bottom is equipped with the air vent, the heating body, set up in outside the chimney, the heating body include sleeve and a plurality of parallel arrangement in heating plate in the sleeve, the heating plate is equipped with a plurality of air current holes, telescopic one end orientation the bottom of chimney. Consequently, heating plate among the heating device in the sleeve will heat the air of chimney bottom side, and when the user absorbed cigarette, during air that the quilt of chimney bottom side heats will get into cigarette through the air vent of chimney bottom, the hot-air got into the back from the one end of cigarette, follows the other end that the cigarette propped up again and wears out to with solid cigarette atomizing, supply the user to suck uniformly, guarantee better smoking taste, promote user experience.

WO2018/201561 A1 discloses a composite ceramic atomizer, comprising a first main body and a second main body, wherein the first main body and the second main body are integrally formed by using a glazing and sealing process, and the first main body is connected to the second main body by means of a glazed surface formed by glazing. The glazed surface completely or partially covers a surface at the joint between the first main body and the second main body. The first main body comprises a heating carrier and a conductive path for heating, the conductive path being formed on a surface of or inside the heating carrier and having a first contact part and a second contact part connected to a power supply. The second main body is used for liquid conduction. Further provided is a method for preparing the composite ceramic atomizer, the method involving sealing and integrally forming a porous ceramic material and a heating ceramic material by means of a glazing and firing process. The composite ceramic atomizer has a high strength and a long service life.

US2015/359262 A1 discloses a preparation method of a porous ceramic, the porous ceramic, and a use thereof in the electronic cigarette. The method of preparing a porous ceramic includes: mixing amorphous silica, aluminium oxide and iron oxide uniformly to obtain a mixture; sintering the mixture at a temperature of 1000° C. to 1400° C. for 0.5 hour to 3 hours to obtain a precursor; grinding the precursor to obtain precursor powder; mixing the precursor powder, sodium silicate, and porogen uniformly to obtain a premix; mixing and extruding the premix with water to obtain a moulded body; and heat preserving the moulded body at a temperature of 200° C. to 600° C. for 1 hour to 6 hours, and sintering the moulded body at a temperature of 700° C. to 1200° C. for 0.5 hour to 3 hours to obtain the porous ceramic.

The existing heating methods include sheet heating (needle heating) and tubular heating, for example, "a smoking product used together with an internal heating component" disclosed by CN201380044053.7, which adopts sheet heating (needle heating); but this heating method has an disadvantage that the centre temperature is high and the surrounding is relatively low, so the tobacco that is close to the sheet heating element is fully carbonized and even scorched while the tobacco in the surroundings has not been carbonized, this may result in tobacco wasting; for another example, "electrically heated smoke system with an internal or external heating device" disclosed by CN201080053099.1, which adopts tubular heating, in tubular heating, the tobacco close to the tube wall is fully carbonized while the tobacco in the centre cannot be fully carbonized, in this case, if the temperature is increased, the cigarette paper may be scorched, which will affect the taste. To sum up, the current heating device has the technical defects of uneven baking, small smoke emission, light taste, and poor user experience, and a contaminant produced by long-time smoking of a heat not burn product will attach to the product, which will bring in odd smell.

### Detailed description of the invention

The present invention is created based on the inventor's in-depth research and continuous experiments on the following issues:
In the related art, the heat not burn product mainly comprises the following three types of heating components:
I. Ceramic heating sheet

The ceramic heating sheet is made of zirconia ceramic substrate + precious metal heating slurry, which is characterized in small size, light weight, accessible high power density, and high thermal efficiency; with excellent thermal characteristics and fast heating speed, it allows for any temperature distribution; it has high reliability and long service life, and excellent acid and alkali resistance; besides, the heating element material will not be oxidized; it also has the advantages of corrosion resistance, high temperature resistance, uniform temperature, good thermal conductivity, and fast thermal compensation.

However, when a ceramic heating sheet is used to heat a smoking product, centre heating will cause uneven temperature distribution over the whole heating element, and the temperature difference between the top and the bottom can be about 100°C, which may result in insufficient baking of the tobacco or even a smell of scorching, and large waste of tobacco, apart from that, it may need to use a special cartridge and a sheet heating element to achieve the desired effect, so the scope of application is restrained.

### II. Cylindrical heating rod

The rod type heating element has high strength and will not be broken; when being heated at high temperature, the ceramic heating element shows good compactness, the heating wire is completely wrapped in the ceramic, and the reliability is high in long-term use; 1000 °C silver brazing process is applied, so the solder joints are stable and able to withstand high temperature of 350°C for long.

However, when the heating wire is used to heat the rod body through the heating wire, the heating wire needs to reach a high temperature to achieve the heating effect, so the heat exchange efficiency is low, and due to high temperature of the heating wire, it may cause the metal ions separated from the heating wire to enter human body by mixing into the smoking airflow, which may endanger the human health.

### III. Ceramic heating cup\heating tube\heating pot

Heating cup\heating tube\heating pot are typical examples of surrounding heating. Circular segmented heating, precise temperature control. But this method has the biggest problem of low heat utilization rate, a part of the heat is absorbed by the tobacco, and the other part is subjected to heat dissipation. If heat preservation is not effective, the smoking set will be hot and affect the user's use.

As mentioned above, a contact type heating and baking technology mainly conducts heat transfer and exchange by way of heat transfer, that is, a heating conductor (such as a ceramic heating element or pin) conducts temperature to the object baked (smoking product). This heating method mainly has two disadvantages of: 1. The baked object (smoking product) has poor thermal conductivity and cannot fully transfer the temperature, which causes uneven baking of the inner and outer side; 2. Various types of objects to be baked have largely different space densities, if a different type of object is baked, it is difficult to guarantee the heating and baking effect, and good effect can only be achieved by using a matching baked object, so the adaptability is poor. To conclude, this type of heating device has technical defects such as uneven baking, small smoke emission, light taste, and poor user experience, which severely restrict the further development and popularized application of the field.

For this purpose, the inventor of the present application has found through a number of research and experiments that smoking itself is a process of air flow, if the air flowing into the smoking product is under relatively high temperature, the hot air can directly act to bake the smoking product; and because the hot air can evenly penetrate into all the tobacco of the baked smoking product with the suction process relatively completely and uniformly, the concern of uneven heating will be effectively solved. Therefore, the smoking product is baked by heating the air and then using the hot air flow during the smoking process to achieve heating, this scheme can achieve good overall heating effect.

However, when the air heating scheme is adopted, first it is necessary to select a suitable heating element to heat the air, and when the heating element heats the air, room temperature air needs to enter the heating element, and the temperature of air should reach 300°C or above after flowing out of the heating element; second, some general smoking habits have to be considered, that is, about 20ml per second must be ensured during temperature rise, and each puff lasts for about 3 seconds, and the heating element needs a total heating efficiency of about 60ml air.

To achieve the above effect, the inventor has learned through a lot of experiments that when a heating wire is used to heat the air, the heating wire should have high temperature, and only when the temperature of the heating wire is up to 600°C or above, it can heat the air flowing through to more than 300°C, and the heating wire will cool quickly as long as air flows by, in this way, each puff of smoking will make the temperature of the heating wire drop by 200-300°C. Therefore, the heating wire needs power compensation during smoking, otherwise it may be difficult to guarantee air heating required for smoking; while, power compensation is performed for the heating wire based on the air flow detected by an air flow sensor, due to small contact area between heating wire and air, this power compensation scheme not only needs high power to achieve the required heating effect, but also has the problem of inaccurate gas temperature after heating, untimely compensation response, which may cause uneven temperature in all directions.

In addition, when heating the flow air to above 300°C by increasing the temperature of the heating wire, the increased temperature of the heating wire may cause the metal ions separated by the heating wire to enter human body by mixing into the smoking airflow, which will endanger the human health.

For the above, the inventor of the present application has concluded through a lot of research that when air heating is used to bake a smoking product, the heating element used to heat the air needs to have a large heating area so as to reduce the temperature difference between the heating element and the air; the heating element also needs high heat capacity to resist against the temperature drop caused after the smoking airflow passes, and high thermal conductivity to reduce the heating preparation time.

For this purpose, the applicant found based on in-depth research on ceramics for years that a larger heating surface area can be obtained by designing a porous structure of the honeycomb ceramics, so that the heating element will have a high air heating efficiency, and the honeycomb ceramic heating element of porous structure is closer to a solid structure and has a higher heat capacity than a ceramic tube of the same size; in addition, the thermal conductivity of alumina material is greater than 30W/MK, which can make the heat conduction faster and more uniformly, thereby obtaining high thermal conductivity. Therefore, the honeycomb ceramic heating element of porous structure can meet the requirement of baking the smoking product by heating air.

The first purpose of the present invention is to provide a ceramic heating element, which is characterized in quick and uniform temperature rising, large heating surface, low power consumption, long service life, and good heat preservation.

In accordance with the present invention there is provided ceramic heating element comprising a honeycomb ceramic body, wherein porous channels are arranged in the honeycomb ceramic body, and the porous channels are circular holes or polygonal holes; and
a heating printed circuit, wherein the heating printed circuit is arranged around the outer surface of the honeycomb ceramic body to heat the air passing through the porous channels, wherein the honeycomb ceramic body is an alumina honeycomb ceramic body, and the alumina honeycomb ceramic body has a density being not less than 3.86 g/cm³, the porous channels being uniformly distributed in the honeycomb ceramic body.

Optionally, the porous channels are arranged in the centre of the honeycomb ceramic body.

Optionally, the honeycomb ceramic body is a cylinder with a circular or polygonal cross section.

Specifically, an alumina honeycomb ceramic heating element proposed by an embodiment of the present invention, comprises an alumina honeycomb ceramic body, a heating printed circuit, and a wire; porous channels are arranged in the centre of the alumina honeycomb ceramic body; and the porous channels are evenly arranged circular or polygonal holes; the heating printed circuit is arranged around the outer surface of the alumina honeycomb ceramic body; and a wire is arranged at a first end of the heating printed circuit.

Further, the resistance of the alumina honeycomb ceramic body is 0.1Ω-2Ω.

Further, the alumina honeycomb ceramic body is a cylinder with a circular, square or polygonal cross section.

Further, the pore diameter of the porous channels is within 0.1 mm -2 mm; the wall thickness of the porous channels is 0.1 mm -0.5 mm.

Further, materials of the heating printed circuit include but are not limited to silver, tungsten, MoMn, and may be any one of other suitable printed circuit materials.

Further, the printing thickness of the heating printed circuit is 0.005 mm to 0.05 mm.

Further, materials of the wire include but are not limited to copper, silver, and nickel, and the diameter is 0.1 mm -0.3 mm.

According to a ceramic heating element of an embodiment of the present invention, the surface made of high purity alumina honeycomb ceramic has high compactness, it is able to effectively prevent absorption of smoke dust particles, thus to effectively preventing odd smell. The high-purity alumina honeycomb ceramic has good thermal conductivity, with a thermal conductivity of 33W/mk; the wall thickness and pore diameter in the honeycomb ceramic structure are both very small, and the thermal conductivity is extremely excellent; the shape of the honeycomb porous can greatly increase the contact area with air, the alumina honeycomb ceramics has large specific area, and high heating efficiency, which is favorable for quickly heating the air. The honeycomb ceramic heating body of the present invention is arranged below a heat not burn product to be baked without contacting; when the user smokes the heat not burn, the air heated by the honeycomb ceramic heating body at the bottom gets into contact with the heat not burn and heat the heat not burn quickly and uniformly; due to the honeycomb porous structure, the air flow rate is restricted to some extent, and the contact time between the hot air and the heat not burn is prolonged, which slows the heat loss and saves energy. When there is no smoking action, the porous honeycomb ceramic can lock the hot air while reducing the outflow of hot air, which will further save energy.

A second purpose of the present invention is to provide an air-heating type heat not burn heating device that can be baked uniformly and will not pollute the product due to a pollutant in fluid or direct-contact of a heating element with a cartridge.

To fulfill this purpose, the air-heating type heat not burn heating device provided by the present invention comprises the ceramic heating element described above; and a preheating device, wherein the ceramic heating element is arranged below the preheating device.

Optionally, the preheating device comprises a preheating tube, a deflector is arranged between the preheating tube and the ceramic heating element, and a plurality of guide holes are arranged on the deflector.

Optionally, the ceramic heating element and the preheating device are arranged in a sealing sleeve.

Optionally, the preheating device comprises a thin-wall alumina ceramic tube for preheating, a cavity in the centre of the thin-wall alumina ceramic tube is used for placing a smoking product, and an opening at one end of the thin-wall alumina ceramic tube and a base plate forms a cup body, and a plurality of hot air flow holes are arranged on the base plate.

Optionally, the thin-wall alumina ceramic tube body has a density not less than 3.86 g/cm³.

Optionally, a plurality of hot air flow holes are uniformly arranged around a virtual circle in the centre of the base plate, and the hot air flow holes are circular holes with a diameter ranging from 0.1mm to 2 mm.

Optionally, the base plate is made of high-purity alumina ceramics.

In one embodiment of the present invention, the air-heating heat not burn heating device comprises a preheating tube and a ceramic heating element, and the ceramic heating element is arranged under the preheating tube; the ceramic heating element comprises a honeycomb ceramic body and a heating printed circuit arranged on the honeycomb ceramic body, a wire is arranged at an end of the heating printed circuit, and honeycomb porous channels are arranged in the ceramic heating body.

Further, the preheating tube, ceramic heating element and deflector are all made of high-purity alumina ceramics.

Further, printing materials of the heating printed circuit include but are not limited to silver, tungsten, and MoMn.

Further, the wire material includes but is not limited to silver, copper, and nickel.

Further, the honeycomb porous channels are uniformly arranged circular holes or polygonal holes, with a pore diameter ranging from 0.1mm to 2 mm, and the minimum distance between two adjacent holes within 0.1mm - 0.5mm.

According to the air-heating heat not burn heating device of the present invention, the air is heated by the heating element, and then the heated flow air evenly bakes the tobacco, in order to achieve the effects of increasing the smoke emissions, creating good smoking taste, and good user experience. The preheating tube, ceramic heating element and deflector are all made of high-purity alumina ceramics, wherein the high-purity alumina ceramics feature high compactness and almost have no pores in microstructure, so penetration of contaminants in the fluid is impossible, and no pollution and odd smell will be left on the surface; and it can ensure that the device is not contaminated as the air heating method does not contact with the cartridge.

In addition, the preheating device can achieve quick and uniform temperature rise, thus to exert the function of preheating and heat preservation.

The preheating device comprises a thin-wall alumina ceramic tube for preheating, a cavity in the centre of the thin-wall alumina ceramic tube is used for placing smoking product; an opening at one end of the thin-wall alumina ceramic tube and a base plate forms a cup body, and a plurality of hot air flow holes are arranged on the base plate.

Further, the alumina ceramic tube body has a density not less than 3.86 g/cm³.

Further, the thin-wall alumina ceramic tube is a thin-wall alumina ceramic hollow circular tube, with the wall thickness ranging from 0.1mm to 0.5 mm.

Further, the shape of the base plate matches with the opening section of the thin-wall alumina ceramic tube.

Further, a plurality of hot air flow holes are uniformly arranged around a virtual circle in the centre of the base plate, and the hot air flow holes are circular holes with a diameter ranging from 0.1mm to 2 mm.

Further, the thickness of the base plate is within 0.1mm-0.5 mm.

Further, the base plate is made of high-purity alumina ceramics.

The preheating device is installed above the air heating element, when the heating element is heated, it can be quickly heated up to preheat the cavity as the base plate and the thin-wall alumina ceramic tube are both made of ultra-thin high-purity alumina ceramics. The thin-wall alumina ceramic tube is not used as a traditional heating component, which can reduce heat loss. Heating the smoking product is achieved by the user's smoking action, and hot air is extracted from the heating component under the hot air flow hole to bake the smoking product, the baking effect is good and the baking is uniform. On one hand, the hot air flow hole can facilitate the circulation of hot air; on the other hand, direct diffusion of hot air is prevented when no one smokes, thus to achieve heat preservation. The high-purity alumina ceramic material has good compactness, which will reduce the absorption of smoke dust particles, generate no odd smell, it is therefore safer to use.

A third purpose of the present invention is to provide a preparation method of the ceramic heating element.

In order to fulfill this purpose, a preparation method of the ceramic heating element proposed in the present invention comprises the following steps:
Step 1: Preparation of alumina ceramic sludge: adding 0.01-0.05 parts (by weight) of magnesium nitrates, 0.01-0.05 parts of zirconium oxychlorides, 0.01-0.05 parts of yttrium nitrates, 1.5-2.5 parts of oleic acids, 1-2 parts of lubricants, 3-15 parts of binder and 10-30 parts of deionized water into 100 parts of nano alumina powders, putting them into a mixing machine, and mix them for 1~ 5h at a temperature below 30°C, thus to prepare the alumina honeycomb ceramic sludge with uniform distribution and a solid content of 75-85% for later use;
Step 2: Molding of alumina honeycomb ceramics: adding the alumina honeycomb ceramic slurry prepared in step 1 into a screw-type ceramic extrusion molding machine with a vacuum degassing device, and extruding hollow, thin-wall honeycomb ceramic blanks out of the ceramic slurry through the die head as pushed by the screw;
Step 3: Drying of alumina honeycomb ceramic blanks: moving the ceramic blanks prepared in step 2 to an oven, make them dry and dehydrate for 5 to 10 minutes under 40°C -50°C hot air, thus to obtain a ceramic green body with satisfactory appearance and straightness;
Step 4: Debinding of the alumina ceramic green body: biscuiting the ceramic green body prepared in step 3 at 1100°C -1200°C to obtain a biscuit ceramic;
Step 5: Firing of alumina honeycomb ceramic: placing the biscuit ceramic prepared in step 4 in a high-temperature molybdenum tube and firing it in a hydrogen atmosphere or directly in the air at 1600-1800°C to obtain an alumina honeycomb ceramic;
Step 6: Preparation of alumina honeycomb ceramic surface heating printed circuit and its wire: print a thick-film electric heating wire on the outer surface of the alumina honeycomb ceramic prepared in step 5 using screen printing technology, after the printed circuit is dried up, apply silver solder on a bonding pad to stick the wire, dry them up in the oven again, and then move them to a furnace for sintering at 800°C-1500°C, thus to obtain an integrally sintered wire and printed circuit, and simultaneously, complete silver soldering of the wire in the furnace.

Optionally, the nano alumina powder used in step 1 has a purity of 99.99% or above, a particle size of 350 nm, and a specific surface area of 7m²/g.

According to an embodiment of the present invention, the purity of the alumina honeycomb ceramics is more than 99.99%, so that the ceramic surface has a high compactness, which can effectively prevent adsorption of smoke and dust particles, thus to exert the effect of preventing odd smell. The high-purity alumina honeycomb ceramic has good thermal conductivity, with a thermal conductivity of 33W/mk; the wall thickness and pore diameter in the honeycomb ceramic structure are both very small, and the thermal conductivity is extremely excellent; the shape of the honeycomb porous can greatly increase the contact area with air, the alumina honeycomb ceramics has large specific area, and high heating efficiency, which is favorable for quickly heating the air. The honeycomb ceramic heating body of the present invention is arranged below a heat not burn product to be baked without contacting; when the user smokes the heat not burn, the air heated by the honeycomb ceramic heating body at the bottom gets into contact with the heat not burn and heat the heat not burn quickly and uniformly; due to the honeycomb porous structure, the air flow rate is restricted to some extent, and the contact time between the hot air and the heat not burn is prolonged, which slows the heat loss and saves energy. When there is no smoking action, the porous honeycomb ceramic can lock the hot air while reducing the outflow of hot air, which will further save energy.

### Description of the Attached Drawings

FIG. 1 is a structural diagram of a heating element according to an embodiment of the present invention;
FIG.2 is a plane expansion diagram of a heating printed circuit on the surface of the alumina honeycomb ceramic heating element according to an embodiment of the present invention;
FIG.3 is a structural diagram of an air-heating type heat not burn heating device according to an embodiment of the present invention;
FIG.4 is a structural diagram of an air-heating type heat not burn heating device according to another embodiment of the present invention;
FIG.5 is a structural diagram of an air-heating type heat not burn heating device according to a third embodiment of the present invention;
FIG.6 is a structural diagram of a deflector according to an embodiment of the present invention;
FIG.7 is a structural diagram of a preheating device according to an embodiment of the present invention.

### Detailed description of embodiments

To make the purpose, technical scheme and advantages of the embodiments of the present invention more clear, in combination with the attached drawings given in the embodiments of the present invention, the technical scheme described in embodiments of the present invention are described explicitly and completely below. Apparently, the embodiments described only represent a part but not all of the embodiments of the present invention.

In the description of the present invention, it should be understood that the terms "above", "below", "inner", "outer", "front end", "rear end", "one end", "the other end", etc. refer to the direction or position based on the attached drawings. The terms are provided only for the convenience of describing the present invention and simplifying the description, rather than indicating or implying that the device or element referred therein must have a specific direction, must be constructed or operated in a specific direction, they can not be construed as a limitation on the present invention. The terms "first" and "second" are for illustrative purpose only, which may not to construed as indicating or implying relative importance.

In the description of the present invention, it should be noted that, unless otherwise expressly specified and defined, the terms "install", "arrange", "connect", etc. should be understood in a broad sense. For example, "connect" may be fixed connection or detachable connection or integral connection; it may be mechanical connection or electrical connection; it may be also direct connection or indirection connection through a medium, or it may be internal communication of two components. For those ordinary technicians skilled in the art, the specific meanings of the above terms quoted in the present invention can be understood according to specific situations.

With reference to the attached drawings, a ceramic heating element, an air-heating type heat not burn heating device with the ceramic heating element, and a preparation method of the ceramic heating element proposed by the embodiments of the present invention are illustrated in detailed below.

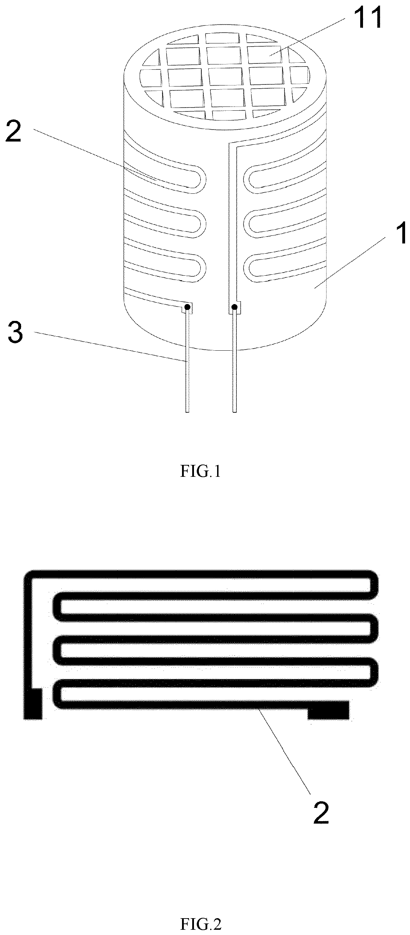

As shown in FIG.1, a ceramic heating element proposed in an embodiment of the present invention comprises a honeycomb ceramic body 1 and a heating printed circuit 2. Wherein, porous channels 11 are arranged in the honeycomb ceramic body, and porous channels 11 are circular or polygonal holes; the heating printed circuit 2 is arranged around the outer surface of the honeycomb ceramic body 1 to heat the air passing through the porous channels 11.

Optionally, as one embodiment, the alumina ceramic tube body is an alumina honeycomb ceramic body, and the alumina honeycomb ceramic body has a density being not less than 3.86 g/cm³.

Optionally, as one embodiment, the porous channels are uniformly distributed in the honeycomb ceramic body.

Optionally, as one embodiment, the porous channels are arranged in the centre of the honeycomb ceramic body.

Optionally, as one embodiment, the honeycomb ceramic body is a cylinder with a circular or polygonal cross section.

With reference to the attached drawings, detailed description of embodiments of the present invention is described in details.

### Embodiment 1:

As shown in Figure 1-2, an alumina honeycomb ceramic heating element disclosed by the present invention, comprises an alumina honeycomb ceramic body 1, a heating printed circuit 2, and a wire 3; porous channels 11 are arranged in the centre of the alumina honeycomb ceramic body 1; and the porous channels 11 are evenly arranged square holes; the heating printed circuit 2 is arranged around the outer surface of the alumina honeycomb ceramic body 1; and a wire 3 is arranged at a first end of the heating printed circuit 2.

Further, the density of the alumina honeycomb ceramic body 1 is 3.9 g/cm³.

Further, the resistance of the alumina honeycomb ceramic body 1 is 0.6Ω.

Further, the alumina honeycomb ceramic body 1 is a cylinder with a circular cross section.

Further, the square hole diameter of the porous channels 11 is 1.5mm, that is, the side length of the square hole is 1.5mm; the wall thickness of the porous channels 11 is 0.2mm; as shown in FIG.1, distance between the corresponding sides of two adjacent square holes is the wall thickness of the porous channels 11.

Further, the heating printed circuit 2 is made of silver.

Further, the printing thickness of the heating printed circuit 2 is 0.015 mm.

Further, the wire 3 is a silver wire, with a diameter of 0.2 mm.

### Embodiment 2:

As shown in Figure 1-2, an alumina honeycomb ceramic heating element disclosed by the present invention, comprises an alumina honeycomb ceramic body 1, a heating printed circuit 2, and a wire 3; porous channels 11 are arranged in the centre of the alumina honeycomb ceramic body 1; and the porous channels 11 are evenly arranged circular holes; the heating printed circuit 2 is arranged around the outer surface of the alumina honeycomb ceramic body 1; and a wire 3 is arranged at a first end of the heating printed circuit 2.

Further, the density of the alumina honeycomb ceramic body 1 is 3.9 g/cm³.

Further, the resistance of the alumina honeycomb ceramic body 1 is 0.852.

Further, the alumina honeycomb ceramic body 1 is a cylinder with a circular cross section, and the porous channels 11 in the centre thereof are square holes.

Further, the circular pore diameter of the porous channels 11 mm is 1.5 mm; the wall thickness of the porous channels 11 is 0.2 mm, and the minimum distance between two adjacent circular holes is the wall thickness of the porous channels 11.

Further, the heating printed circuit 2 is made of silver.

Further, the printing thickness of the heating printed circuit 2 is 0.02 mm.

Further, the wire 3 is a silver wire, with a diameter of 0.2 mm.

In this embodiment, the porous channels 11 are circular holes, in comparison with the embodiment 1, the utilization rate of the centre of the alumina honeycomb ceramic body 1 is obviously lower than that of the embodiment 1, and its specific surface area is smaller than that of the embodiment 1, and the heating efficiency is lower than that of the embodiment 1.

In the present invention, the purity of the alumina honeycomb ceramics is more than 99%, so that the honeycomb ceramic surface has high compactness, which can effectively prevent adsorption of smoke and dust particles, thus to exert the effect of preventing odd smell. The high-purity alumina honeycomb ceramic has good thermal conductivity, with a thermal conductivity of 33W/mk; the wall thickness and pore diameter in the honeycomb ceramic structure are both very small, and the thermal conductivity is extremely excellent; the shape of the honeycomb porous can greatly increase the contact area with air, the alumina honeycomb ceramics has large specific area, and high heating efficiency, which is favorable for quickly heating the air.

The honeycomb ceramic heating body of the present invention is arranged below a heat not burn product to be baked without contacting; when the user smokes the heat not burn, air flows through the holes in the honeycomb of the heating element and is heated to a certain temperature, and then the hot air flows through the heat not burn to rapidly heat the heat not burn to 320°C. This method can improve the heating area and heating efficiency of heat not burn product, achieve even heating, carbonize tobacco more completely, avoid wasting of tobacco, improve the smoking experience of users, and it is not limited by the type of cartridge. Due to the honeycomb porous structure, the air flow rate is restricted to some extent, and the contact time between the hot air and the heat not burn is prolonged, which slows the heat loss and saves energy. When there is no smoking action, the porous honeycomb ceramic can lock the hot air while reducing the outflow of hot air, which will further save energy.

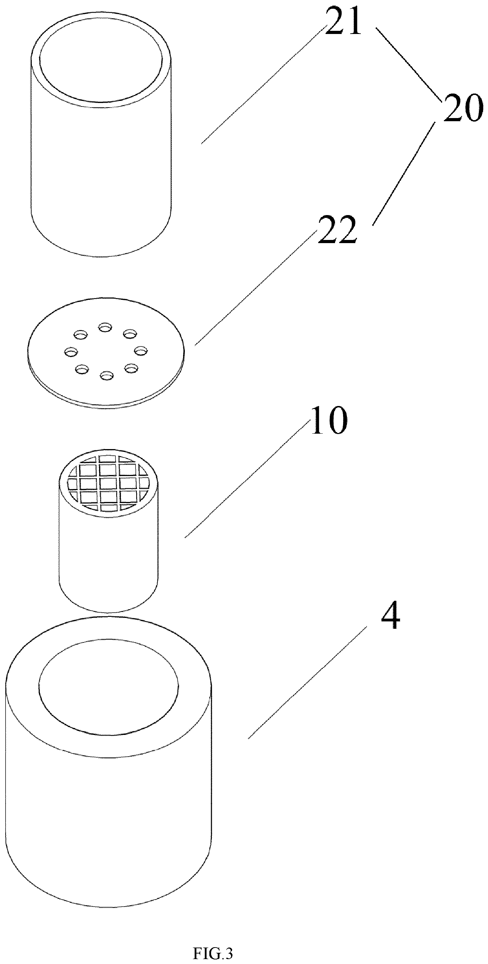

The embodiment of the present invention further discloses an air-heating type heat not burn heating device, as shown in FIG.3, the air-heating type heat not burn heating device comprises the ceramic heating element described in the embodiment 10 and the preheating device 20.

A ceramic heating element 10 is arranged below the preheating device 20.

Optionally, as one embodiment, the preheating device comprises a preheating tube, a deflector is arranged between the preheating tube and the ceramic heating element, and a plurality of guide holes are arranged on the deflector.

According one embodiment of the present invention, the ceramic heating element and the preheating device are arranged in a sealing sleeve.

Optionally, as one embodiment, the preheating device comprises a thin-wall alumina ceramic tube for preheating, a cavity in the centre of the thin-wall alumina ceramic tube is used for placing a smoking product, and an opening at one end of the thin-wall alumina ceramic tube and a base plate forms a cup body, and a plurality of hot air flow holes are arranged on the base plate.

Wherein, the thin-wall alumina ceramic tube body has a density not less than 3.86 g/cm³.

Optionally, as one embodiment, a plurality of hot air flow holes are uniformly arranged around a virtual circle in the centre of the base plate, and the hot air flow holes are circular holes with a diameter ranging from 0.1mm to 2 mm.

The base plate is made of high-purity alumina ceramics.

Specifically, as one embodiment, as shown in FIGS.1-3, the air-heating heat not burn heating device comprises a preheating tube 21 and a ceramic heating element 10, and the ceramic heating element 10 is arranged under the preheating tube 21; the ceramic heating element 10 comprises a honeycomb ceramic body 1 and a heating printed circuit 2 arranged on the honeycomb ceramic body 1, a wire 3 is arranged at an end of the heating printed circuit 2, and honeycomb porous channels 11 are arranged in the ceramic heating body 1.

Further, a deflector 22 is arranged between the preheating tube 21 and the ceramic heating element 10, and a plurality of guide holes 31 are arranged on the deflector 22.

Further, the preheating tube 21 and the ceramic heating element 10 are arranged in a sealing sleeve 4.

Further, the preheating tube 21, ceramic heating element 10 and deflector 22 are all made of high-purity alumina ceramics.

Further, printing materials of the heating printed circuit 2 include but are not limited to silver, tungsten, and MoMn.

Further, the wire 2 material includes but is not limited to silver, copper, and nickel.

Further, the honeycomb porous channels 11 are uniformly arranged circular holes or polygonal holes, with a pore diameter ranging from 0.1mm to 2 mm, and the minimum distance between two adjacent holes within 0.1mm - 0.5mm.

Optionally, as one embodiment, as shown in FIG 3, a ceramic heating element 10 is arranged under the preheating tube 21, and a deflector 22 is arranged between the preheating tube 21 and the ceramic heating element 10, the preheating tube 21 and the ceramic heating element 10 are arranged inside a sealing sleeve 4; as shown in FIG.1, the ceramic heating element 10 comprises a honeycomb ceramic body 1, and a heating printed circuit 2 arranged on the honeycomb ceramic body 1, a wire 3 is arranged at an end of the heating printed circuit 2. When a smoker desires to smoke, he/she may put a cartridge into the preheating tube 21 to prevent the cartridge from falling; after powering on, the heating printed circuit 2 starts to heat, because the effective ingredients such as nicotine can only be heated to generate the smoke to smoke only when the cartridge is baked at 280°C-320°C, so it is necessary to preheat the device, and preheating is deemed as completed when the temperature of the preheating tube 21 and the deflector 22 reaches 200°C, the preheating is completed. Since the preheating is completed, at the time of a first and second puffs during the first heating, the cartridge only needs to be heated from 200°C to 320°C, which is faster than rising from the room temperature, and can better guarantee the smoke volume produced by the first and second puffs. To speed up heating, a honeycomb porous channel 11 is arranged in the honeycomb ceramic body 1 and the porous channels are uniformly arranged square holes or other polygonal holes, with the pore diameter ranging from 0.1mm to 2mm, and the minimum distance between two adjacent holes within 0.1mm-0.5mm, and the expanded area is large, the air-heating efficiency is very high, and the heated air flows from the centre of the honeycomb without contacting the heating printed circuit 2, so it will not cause pollution. As the preheating tube 21, the ceramic heating element 10 and the deflector 22 are all made of high-purity alumina ceramics featuring good electrical insulation, high strength, and good thermal conductivity, so the ceramic heating element 10 will not leak when being heated, and the preheating tube 21 and the deflector 22 will be heated up because of the good thermal conductivity of high-purity alumina ceramics, the user can smoke the cartridge soon; during smoking the airflow is heated to 320°C by the ceramic heating element 10, then further homogenized and diverted through the diversion holes 31 on the deflector 22 and finally flows into the cartridge more evenly to heat the tobacco, so as to increase the smoke volume, improve the smoking taste, and provide good user experience. During smoking, some fluid contaminants emitted from the cartridge may inevitably remain in the device. As the high-purity alumina ceramics feature high compactness and almost have no pores in microstructure, so penetration of contaminants in fluid is impossible, and no pollution and odd smell will be left on the surface; In the working process, the sealing sleeve 4 serves as a seal, which ensures that the heated air will not flow to other places.

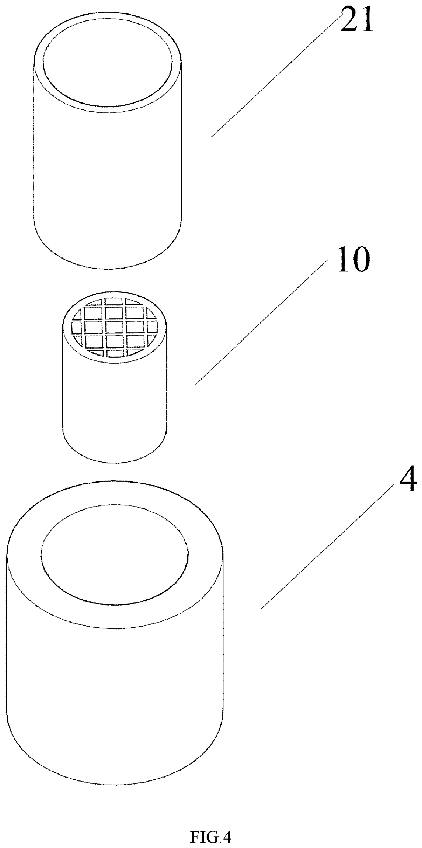

Optionally, as another embodiment, as shown in FIG 4, a ceramic heating element 10 is arranged under the preheating tube 21, and the preheating tube 21 and the ceramic heating element 10 are arranged inside a sealing sleeve 4; as shown in FIG. 1, the ceramic heating element 10 comprises a honeycomb ceramic body 1, and a heating printed circuit 2 arranged on the honeycomb ceramic body 1, a wire 3 is arranged at an end of the heating printed circuit 2. When a smoker desires to smoke, he/she may put a cartridge into the preheating tube 21 to prevent the cartridge from falling; after powering on, the heating printed circuit 2 starts to heat, because the effective ingredients such as nicotine can only be heated to generate the smoke to smoke only when the cartridge is baked at 280°C-320°C, so it is necessary to preheat the device, and preheating is deemed as completed when the temperature of the preheating tube 21 reaches 200°C, the preheating is completed. Since the preheating is completed, at the time of a first and second puffs during the first heating, the cartridge only needs to be heated from 200°C to 320°C, which is faster than rising from the room temperature, and can better guarantee the smoke volume produced by the first and second puffs. To speed up heating, a honeycomb porous channel 11 is arranged in the honeycomb ceramic body 1 and the porous channels are uniformly arranged square holes or other polygonal holes, with the pore diameter ranging from 0.1mm to 2mm, and the minimum distance between two adjacent holes within 0.1mm-0.5mm, and the expanded area is large, the air-heating efficiency is very high, and the heated air flows from the centre of the honeycomb without contacting the heating printed circuit 2, so it will not cause pollution. As the preheating tube 21 and the ceramic heating element 10 are made of high-purity alumina ceramics featuring good electrical insulation, high strength, and good thermal conductivity, so the ceramic heating element 10 will not leak when being heated, and the preheating tube 21 will be heated up because of the good thermal conductivity of high-purity alumina ceramics, the user can smoke the cartridge soon; during smoking the airflow is heated to 320°C by the ceramic heating element 10, when the smoker starts to smoke, the heated air flows to the preheating tube 21 through the ceramic heating element 10, and the heated air flows into the cartridge to evenly heat the tobacco then further homogenized and diverted through the diversion holes 10 on the deflector 22 and finally flows into the cartridge more evenly to heat the tobacco, so as to increase the smoke volume, improve the smoking taste, and provide good user experience. During smoking, some fluid contaminants emitted from the cartridge may inevitably remain in the device. As the high-purity alumina ceramics feature high compactness and almost have no pores in microstructure, so penetration of contaminants in fluid is impossible, and no pollution and odd smell will be left on the surface; In the working process, the sealing sleeve 4 serves as a seal, which ensures that the heated air will not flow to other places.

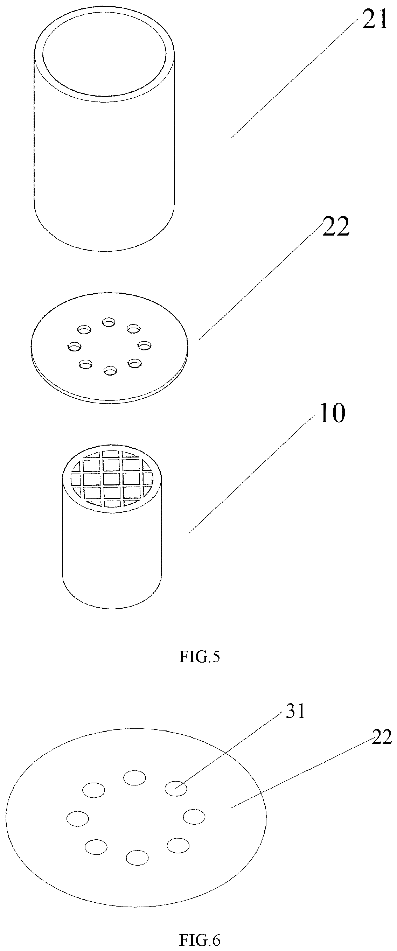

Optionally, as one embodiment, as shown in FIG 5, a ceramic heating element 10 is arranged under the preheating tube 21, and a deflector 22 is arranged on the preheating tube 21 and the ceramic heating element 10; as shown in FIG.1, the ceramic heating element 10 comprises a honeycomb ceramic body 1, and a heating printed circuit 2 arranged on the honeycomb ceramic body 1, a wire 3 is arranged at an end of the heating printed circuit 2. When a smoker desires to smoke, he/she may put a cartridge into the preheating tube 21 to prevent the cartridge from falling; after powering on, the heating printed circuit 2 starts to heat, because the effective ingredients such as nicotine can only be heated to generate the smoke to smoke only when the cartridge is baked at 280°C-320°C, so it is necessary to preheat the device, and preheating is deemed as completed when the temperature of the preheating tube 21 and the deflector 22 reaches 200°C, the preheating is completed. Since the preheating is completed, at the time of a first and second puffs during the first heating, the cartridge only needs to be heated from 200°C to 320°C, which is faster than rising from the room temperature, and can better guarantee the smoke volume produced by the first and second puffs. To speed up heating, a honeycomb porous channel 11 is arranged in the honeycomb ceramic body 1 and the porous channels are uniformly arranged square holes or other polygonal holes, with the pore diameter ranging from 0.1mm to 2mm, and the minimum distance between two adjacent holes within 0.1mm-0.5mm, and the expanded area is large, the air-heating efficiency is very high, and the heated air flows from the centre of the honeycomb without contacting the heating printed circuit 2, so it will not cause pollution. As the preheating tube 21, the ceramic heating element 10 and the deflector 22 are all made of high-purity alumina ceramics featuring good electrical insulation, high strength, and good thermal conductivity, so the ceramic heating element 10 will not leak when being heated, and the preheating tube 21 and the deflector 22 will be heated up because of the good thermal conductivity of high-purity alumina ceramics, the user can smoke the cartridge soon; during smoking the airflow is heated to 320°C by the ceramic heating element 10, then further homogenized and diverted through the diversion holes 31 on the deflector 22 and finally flows into the cartridge more evenly to heat the tobacco, so as to increase the smoke volume, improve the smoking taste, and provide good user experience. During smoking, some fluid contaminants emitted from the cartridge may inevitably remain in the device. As the high-purity alumina ceramics feature high compactness and almost have no pores in microstructure, so penetration of contaminants in fluid is impossible, and no pollution and odd smell will be left on the surface.

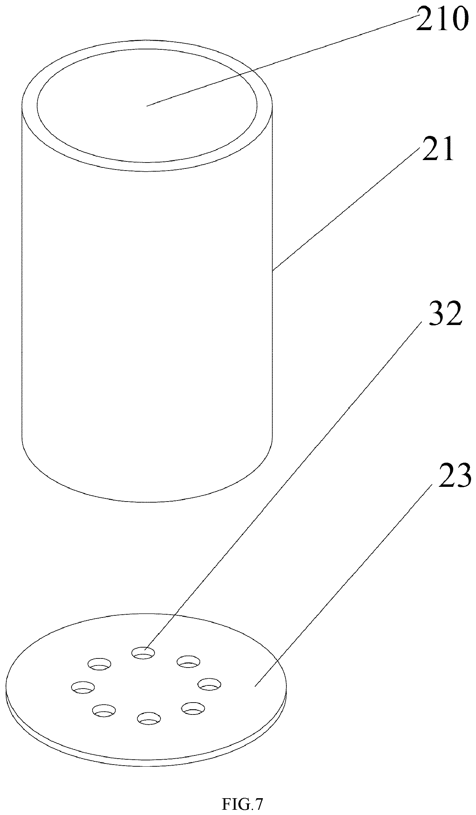

As one embodiment, as shown in FIG.7, the preheating device comprises a thin-wall alumina ceramic tube for preheating, a cavity 210 in the centre of the thin-wall alumina ceramic tube 21 is used for placing a tobacco product such as cartridge, and an opening at one end of the thin-wall alumina ceramic tube 21 and a base plate 23 forms a cup body, and a plurality of hot air flow holes 32 are arranged on the base plate 23; the thin-wall alumina ceramic tube body 21 has a density that is not less than 3.86 g/cm³; the thin-wall alumina ceramic tube 21 is a thin-wall alumina ceramic hollow circular tube, with the wall thickness of 0.2mm; the shape of the base plate 23 matches with that of an opening section of the thin-wall alumina ceramic tube 21; 8 hot air flow holes 32 are uniformly arranged around a virtual circle in the centre of the base plate 23, and the hot air flow holes 32 are circular holes with a diameter of 1.5mm; and the base plate 23 has a thickness of 0.2mm; and the base plate 23 is made of high-purity alumina ceramics.

Wherein, the purity of the ultra-thin high-purity alumina ceramics is more than 99%, so that the ceramic surface has high compactness, which can effectively prevent adsorption of smoke and dust particles, thus to exert the effect of preventing odd smell. Ultra-thin high-purity alumina ceramics have good thermal conductivity (thermal conductivity up to 33W/m.k), and high heating efficiency, so it can quickly achieve the purpose of preheating the air in cavity 210.

The preheating device is installed above the air heating element such as a ceramic heating element 10, when the heating element is heated, it can be quickly heated up to preheat the cavity 210 as the base plate 23 and the thin-wall alumina ceramic tube 21 are both made of ultra-thin high-purity alumina ceramics. The thin-wall alumina ceramic tube 21 is not used as a traditional heating component, which can reduce heat loss. In a heating scheme in a related art, a ceramic heating tube is used to bake a a smoking product directly, a heating circuit is printed on the outer surface of the ceramic heating tube, when the power is on, the high temperature of the ceramic heating tube itself will bake the smoking product, in this way, the heat utilization rate is low, and a lot of heat is released while baking the tobacco, which does not economic and environmental friendly. In the embodiments of the present invention, heating the smoking product is achieved by the user's smoking action, and hot air is extracted from the heating component under the hot air flow hole 32 to bake the smoking product, the baking effect is good and the baking is uniform. On one hand, the hot air flow hole can facilitate the circulation of hot air; on the other hand, direct diffusion of hot air is prevented when no one smokes, thus to achieve heat preservation. The high-purity alumina ceramic material has good compactness, which will reduce the absorption of smoke dust particles, generate no odd smell, it is therefore safer to use.

Besides, an embodiment of the present invention further discloses a preparation method of the ceramic heating element, which comprises the following steps:
Step 1: Preparation of alumina ceramic sludge: adding 0.01-0.05 parts (by weight) of magnesium nitrate, 0.01-0.05 parts of zirconium oxychloride, 0.01-0.05 parts of yttrium nitrate, 1.5-2.5 parts of oleic acid, 1-2 parts of lubricant, 3-15 parts of binders and 10-30 parts of deionized water into 100 parts of nano alumina powder, putting them into a mixing machine, and mix them for 1~ 5h at a temperature below 30°C, thus to prepare the alumina honeycomb ceramic sludge with uniform distribution and a solid content of 75-85% for later use;
Step 2: Molding of alumina honeycomb ceramics: adding the alumina honeycomb ceramic slurry prepared in step 1 into a screw-type ceramic extrusion molding machine with a vacuum degassing device, and extruding hollow, thin-wall honeycomb ceramic blanks out of the ceramic slurry through the die head as pushed by the screw;
Step 3: Drying of alumina honeycomb ceramic blanks: moving the ceramic blanks prepared in step 2 to an oven, make them dry and dehydrate for 5 minutes to 10 minutes under 40°C -50°C hot air, thus to obtain a ceramic green body with satisfactory appearance and straightness;
Step 4: Debinding of the alumina ceramic green body: biscuiting the ceramic green body prepared in step 3 at 1100-1200°C to obtain a biscuit ceramic;
Step 5: Firing of alumina honeycomb ceramic: placing the biscuit ceramic prepared in step 4 in a high-temperature molybdenum tube and firing it in a hydrogen atmosphere or directly in the air at 1600-1800°C to obtain an alumina honeycomb ceramic;
Step 6: Preparation of alumina honeycomb ceramic surface heating printed circuit and its wire: print a thick-film electric heating wire on the outer surface of the alumina honeycomb ceramic prepared in step 5 using screen printing technology, after the printed circuit is dried up, apply silver solder on a bonding pad to stick the wire, dry them up in the oven again, and then move them to a furnace for sintering at 800°C-1500°C, thus to obtain an integrally sintered wire and printed circuit, and simultaneously, complete silver soldering of the wire in the furnace.

Optionally, the nano alumina powder used in step 1 has a purity of 99.99% or above, a particle size of 350 nm, and a specific surface area of 7m²/g.

According to one embodiment of the present invention, the preparation method of the said alumina honeycomb ceramic heating element comprises the following steps:
Step 1: Preparation of alumina ceramic sludge: adding 0.04 parts (by weight) of Mg(NO₃)₂•6H₂O, 0.04 parts of ZrOCl₂•8H₂O, 0.01 part of Y(NO₃)₃•6H₂O, 2.4 parts of oleic acid, 1.2 parts of polyethylene glycol 600, 14 parts of high-purity ethyl cellulose ether and 12 parts of deionized water in 100 parts of nano alumina powder, and then placing the mixture in a mixing machine, and mix them for 5h at a temperature below 30°C, thus to prepare the alumina honeycomb ceramic sludge with uniform distribution and a solid content of 75% for later use;
Step 2: Molding of alumina honeycomb ceramics: adding the alumina honeycomb ceramic slurry prepared in step 1 into a screw-type ceramic extrusion molding machine with a vacuum degassing device, and extruding hollow, thin-wall honeycomb ceramic blanks out of the ceramic slurry through the die head as pushed by the screw;
Step 3: Drying of alumina honeycomb ceramic blanks: moving the ceramic blanks prepared in step 2 to an oven, make them dry and dehydrate for 10 minutes under 49°C hot air, thus to obtain a ceramic green body with satisfactory appearance and straightness;
Step 4: Debinding of the alumina ceramic tube green: biscuiting the ceramic green body prepared in step 3 at 1190°C to obtain a biscuit ceramic;
Step 5: Firing of alumina ceramic: placing the biscuit ceramic prepared in step 4 in a high-temperature molybdenum tube and firing it in a hydrogen atmosphere or directly in the air at 1650°C to obtain an alumina honeycomb ceramic;
Step 6: Preparation of heating a printed circuit and its wire on alumina ceramic tube surface: print a thick-film electric heating wire on the outer surface of the alumina honeycomb ceramic prepared in step 5 using screen printing technology, after the printed circuit is dried up, apply silver solder on a bonding pad to stick the wire, dry them up in the oven again, and then move them to an atmospheric hydrogen furnace for sintering at 800°C, thus to obtain the heating component of an integrally sintered alumina honeycomb ceramic body, and simultaneously, complete silver soldering of the wire in the furnace.

Further, the nano alumina powder used in step 1 has a purity of 99.99% or above, a particle size of 350 nm, and a specific surface area of 7m²/g.

Further, the density of the alumina honeycomb ceramic body is 3.9 g/cm³.

Further, the resistance of the alumina honeycomb ceramic body is 0.652.

Further, the alumina honeycomb ceramic body is a cylinder with a circular cross section, and the porous channels in the centre thereof are evenly distributed square holes.

Further, the square hole diameter of the porous channels is 1.5mm, that is, the side length of the square hole is 1.5mm; the wall thickness of the porous channels is 0.2mm; as shown in FIG.1, distance between the corresponding sides of two adjacent square holes is the wall thickness of the porous channels.

Further, the heating printed circuit is made of silver.

Further, the printing thickness of the heating printed circuit is 0.015 mm.

Further, the wire is a silver wire, with a diameter of 0.2 mm.

According to another embodiment of the present invention, the preparation method of the said alumina honeycomb ceramic heating element comprises the following steps:
Step 1: Preparation of alumina ceramic sludge: adding 0.02 parts (by weight) of Mg(NO₃)₂•6H₂O, 0.05 parts of ZrOCl₂•8H₂O, 0.015 part of Y(NO₃)₃•6H₂O, 2 parts of oleic acid, 1.5 parts of polyethylene glycol 600, 8 parts of high-purity ethyl cellulose ether and 20 parts of deionized water in 100 parts of nano alumina powder, and then placing the mixture in a mixing machine, and mix them for 5h at a temperature below 30°C, thus to prepare the alumina honeycomb ceramic sludge with uniform distribution and a solid content of 78 for later use;
Step 2: Molding of alumina honeycomb ceramics: adding the alumina honeycomb ceramic slurry prepared in step 1 into a screw-type ceramic extrusion molding machine with a vacuum degassing device, and extruding hollow, thin-wall honeycomb ceramic blanks out of the ceramic slurry through the die head as pushed by the screw;
Step 3: Drying of alumina honeycomb ceramic blanks: moving the ceramic blanks prepared in step 2 to an oven, make them dry and dehydrate for 10 minutes under 49°C hot air, thus to obtain a ceramic green body with satisfactory appearance and straightness;
Step 4: Debinding of the alumina ceramic tube green: biscuiting the ceramic green body prepared in step 3 at 1190°C to obtain a biscuit ceramic;
Step 5: Firing of alumina ceramic: placing the biscuit ceramic prepared in step 4 in a high-temperature molybdenum tube and firing it in a hydrogen atmosphere or directly in the air at 1650°C to obtain an alumina honeycomb ceramic;
Step 6: Preparation of heating a printed circuit and its wire on alumina ceramic tube surface: print a thick-film electric heating wire on the outer surface of the alumina honeycomb ceramic prepared in step 5 using screen printing technology, after the printed circuit is dried up, apply silver solder on a bonding pad to stick the wire, dry them up in the oven again, and then move them to an atmospheric hydrogen furnace for sintering at 800°C, thus to obtain the heating component of an integrally sintered alumina honeycomb ceramic body, and simultaneously, complete silver soldering of the wire in the furnace.

Further, the nano alumina powder used in step 1 has a purity of 99.99% or above, a particle size of 350 nm, and a specific surface area of 7m²/g.

Further, the density of the alumina honeycomb ceramic body is 3.9 g/cm³.

Further, the resistance of the alumina honeycomb ceramic body is 0.8Ω.

Further, the alumina honeycomb ceramic body is a cylinder with a circular cross section, and the porous channels in the centre thereof are evenly distributed square holes.

Further, the square hole diameter of the porous channels is 1.5mm, that is, the side length of the square hole is 1.5mm; the wall thickness of the porous channels is 0.2mm; as shown in FIG. 1, distance between the corresponding sides of two adjacent square holes is the wall thickness of the porous channels.

Further, the heating printed circuit is made of silver.

Further, the printing thickness of the heating printed circuit is 0.02 mm.

Further, the wire is a silver wire, with a diameter of 0.2 mm.

The purity of the alumina honeycomb ceramics prepared by the preparation method of the present invention is more than 99%, so that the honeycomb ceramic surface has high compactness, which can effectively prevent adsorption of smoke and dust particles, thus to exert the effect of preventing odd smell. The high-purity alumina honeycomb ceramic has good thermal conductivity, with a thermal conductivity of 33W/mk; the wall thickness and pore diameter in the honeycomb ceramic structure are both very small, and the thermal conductivity is extremely excellent; the shape of the honeycomb porous can greatly increase the contact area with air, the alumina honeycomb ceramics has large specific area, and high heating efficiency, which is favorable for quickly heating the air.

The honeycomb ceramic heating element of the present invention is arranged below a heat not burn product to be baked without contacting; when the user smokes the heat not burn, air flows through the holes in the honeycomb of the heating element and is heated to a certain temperature, and then the hot air flows through the heat not burn to rapidly heat the heat not burn to 320°C. This method can improve the heating area and heating efficiency of heat not burn product, achieve even heating, carbonize tobacco more completely, avoid wasting of tobacco, improve the smoking experience of users, and it is not limited by the type of cartridge. Due to the honeycomb porous structure, the air flow rate is restricted to some extent, and the contact time between the hot air and the heat not burn is prolonged, which slows the heat loss and saves energy. When there is no smoking action, the porous honeycomb ceramic can lock the hot air while reducing the outflow of hot air, which will further save energy.

Although the embodiments of the present invention have been shown and described above, it can be understood that the embodiments are exemplary but should not be construed as a limitation on the present invention, the ordinary technician skilled in the art may make changes, modifications, substitutions and variations of the embodiments within the scope of the present invention.

## Claims

1. A ceramic heating element, comprising:
a honeycomb ceramic body (1), wherein porous channels (11) are arranged in the honeycomb ceramic body (1), and the porous channels (11) are circular holes or polygonal holes; and
a heating printed circuit (2), wherein the heating printed circuit (2) is arranged around the outer surface of the honeycomb ceramic body (1) to heat the air passing through the porous channels (11), **characterised in that** the honeycomb ceramic body (1) is an alumina honeycomb ceramic body (1), the alumina honeycomb ceramic body (1) has a density being not less than 3.86 g/cm³, and the porous channels (11) are uniformly distributed in the honeycomb ceramic body (1).

2. The ceramic heating element of the claim 1, wherein the porous channels (11) are arranged in the centre of the honeycomb ceramic body (1).

3. The ceramic heating element of any one of claims 1-2, wherein, the honeycomb ceramic body (1) is a cylinder with a circular or polygonal cross section.

4. An air-heating type heat not burn heating device, comprising:
A ceramic heating element of any one of claims 1-3;
A preheating device (20), wherein the ceramic heating element is arranged below the preheating device (20).

5. The air-heating type heat not burn heating device of the claim 4, wherein the preheating device (20) comprises a preheating tube (21), a deflector (22) is arranged between the preheating tube (21) and the ceramic heating element, and a plurality of guide holes (31) are arranged on the deflector (22).

6. The air-heating type heat not burn heating device of the claim 4, wherein the ceramic heating element and the preheating device (20) are arranged in a sealing sleeve (4).

7. The air-heating type heat not burn heating device of the claim 4, wherein the preheating device (20) comprises a thin-wall alumina ceramic tube for preheating, a cavity (210) in the centre of the thin-wall alumina ceramic tube is suitable for placing smoking product; an opening at one end of the thin-wall alumina ceramic tube and a base plate (23) forms a cup body, and a plurality of hot air flow holes are arranged on the base plate (23).

8. The non-contact air-heating type heat not burn heating device of the claim 7, wherein the thin-wall alumina ceramic tube body (1) has a density not less than 3.86 g/cm³.

9. The air-heating type heat not burn heating device of the claim 7, wherein a plurality of hot air flow holes (32) are uniformly arranged around a virtual circle in the centre of the base plate (23), and the hot air flow holes (32) are circular holes with a diameter ranging from 0.1mm to 2 mm.

10. The air-heating type heat not burn heating device of the claim 7, wherein the base plate (23) is made of high-purity alumina ceramics.

11. The preparation method of the ceramic heating element of any one of claims 1-3, wherein the preparation method comprises the following steps:
Step 1: Preparation of alumina ceramic sludge: adding 0.01-0.05 parts (by weight) of magnesium nitrate, 0.01-0.05 parts of zirconium oxychloride, 0.01-0.05 parts of yttrium nitrate, 1.5-2.5 parts of oleic acid, 1-2 parts of lubricant, 3-15 parts of binder and 10-30 parts of deionized water into 100 parts of nano alumina powder, putting them into a mixing machine, and mix them for 1~ 5h at a temperature below 30°C, thus to prepare the alumina honeycomb ceramic sludge with uniform distribution and a solid content of 75-85% for later use;
Step 2: Molding of alumina honeycomb ceramics: adding the alumina honeycomb ceramic slurry prepared in step 1 into a screw-type ceramic extrusion molding machine with a vacuum degassing device, and extruding hollow, thin-wall honeycomb ceramic blanks out of the ceramic slurry through the die head as pushed by the screw;
Step 3: Drying of alumina honeycomb ceramic blanks: moving the ceramic blanks prepared in step 2 to an oven, make them dry and dehydrate for 5 to 10 minutes under 40 -50°C hot air, thus to obtain a ceramic green body with satisfactory appearance and straightness;
Step 4: Debinding of the alumina ceramic green body: biscuiting the ceramic green body prepared in step 3 at 1100-1200°C to obtain a biscuit ceramic;
Step 5: Firing of alumina honeycomb ceramic: placing the biscuit ceramic prepared in step 4 in a high-temperature molybdenum tube and firing it in a hydrogen atmosphere or directly in the air at 1600-1800°C to obtain an alumina honeycomb ceramic;
Step 6: Preparation of alumina honeycomb ceramic surface heating printed circuit (2) and its wire (3): print a thick-film electric heating wire (3) on the outer surface of the alumina honeycomb ceramic prepared in step 5 using screen printing technology, after the printed circuit (2) is dried up, apply silver solder on a bonding pad to stick the wire, dry them up in the oven again, and then move them to a furnace for sintering at 800°C-1500°C, thus to obtain an integrally sintered wire and printed circuit, and simultaneously, complete silver soldering of the wire in the furnace.

12. The preparation method of the ceramic heating element of claim 11, wherein the nano alumina powder used in step 1 has a purity of 99.99% or above, a particle size of 350 nm, and a specific surface area of 7m²/g.

## Patentansprüche

1. Keramisches Heizelement, umfassend:
einen Wabenkeramikkörper (1), wobei poröse Kanäle (11) in dem Wabenkeramikkörper (1) angeordnet sind und die porösen Kanäle (11) kreisförmige Löcher oder polygonale Löcher sind; und
einen gedruckten Heizschaltkreis (2), wobei der gedruckte Heizschaltkreis (2) um die äußere Oberfläche des Wabenkeramikkörpers (1) herum angeordnet ist, um die Luft, welche durch die porösen Kanäle (11) strömt, zu erhitzen, **dadurch gekennzeichnet, dass** der Wabenkeramikkörper (1) ein Aluminiumoxidwabenkeramikkörper (1) ist, der Aluminiumoxidwabenkeramikkörper (1) eine Dichte von nicht weniger als 3,86 g/cm³ aufweist und die porösen Kanäle (11) gleichmäßig in dem Wabenkeramikkörper (1) verteilt sind.

2. Keramisches Heizelement nach Anspruch 1, wobei die porösen Kanäle (11) in der Mitte des Wabenkeramikkörpers (1) angeordnet sind.

3. Keramisches Heizelement nach einem der Ansprüche 1-2, wobei der Wabenkeramikkörper (1) ein Zylinder mit einem kreisförmigen oder polygonalen Querschnitt ist.

4. Tabakerhitzungsvorrichtung vom Luftheiztyp, umfassend:
ein keramisches Heizelement nach einem der Ansprüche 1-3;
eine Vorheizvorrichtung (20), wobei das keramische Heizelement unterhalb der Vorheizvorrichtung (20) angeordnet ist.

5. Tabakerhitzungsvorrichtung vom Luftheiztyp nach Anspruch 4, wobei die Vorheizvorrichtung (20) ein Vorheizrohr (21) umfasst, ein Deflektor (22) zwischen dem Vorheizrohr (21) und dem keramischen Heizelement angeordnet ist und eine Vielzahl von Führungslöchern (31) auf dem Deflektor (22) angeordnet ist.

6. Tabakerhitzungsvorrichtung vom Luftheiztyp nach Anspruch 4, wobei das keramische Heizelement und die Vorheizvorrichtung (20) in einer Dichtungshülse (4) angeordnet sind.

7. Tabakerhitzungsvorrichtung vom Luftheiztyp nach Anspruch 4, wobei die Vorheizvorrichtung (20) ein dünnwandiges Aluminiumoxidkeramikrohr zum Vorheizen umfasst, ein Hohlraum (210) in der Mitte des dünnwandigen Aluminiumoxidkeramikrohrs zum Platzieren eines Rauchprodukts geeignet ist; eine Öffnung an einem Ende des dünnwandigen Aluminiumoxidkeramikrohrs und eine Grundplatte (23) einen Becherkörper bilden und eine Vielzahl von Löchern für Strömung von heißer Luft auf der Grundplatte (23) angeordnet sind.

8. Kontaktfreie Tabakerhitzungsvorrichtung vom Luftheiztyp nach Anspruch 7, wobei der dünnwandige Aluminiumoxidkeramikrohrkörper (1) eine Dichte von nicht weniger als 3,86 g/cm³ aufweist.

9. Tabakerhitzungsvorrichtung vom Luftheiztyp nach Anspruch 7, wobei eine Vielzahl von Löchern (32) für Strömung von heißer Luft gleichmäßig um einen gedachten Kreis in der Mitte der Grundplatte (23) angeordnet ist und die Löcher (32) für Strömung von heißer Luft kreisförmige Löcher mit einem Durchmesser im Bereich von 0,1 mm bis 2 mm sind.

10. Tabakerhitzungsvorrichtung vom Luftheiztyp nach Anspruch 7, wobei die Grundplatte (23) aus hochreiner Aluminiumoxidkeramik besteht.

11. Herstellungsverfahren für das keramische Heizelement nach einem der Ansprüche 1-3, wobei das Herstellungsverfahren die folgenden Schritte umfasst:
Schritt 1: Herstellung eines Aluminiumoxidkeramikschlamms: Hinzufügen von 0,01-0,05 (Gew.-)Teilen Magnesiumnitrat, 0,01-0,05 Teilen Zirkoniumoxychlorid, 0,01-0,05 Teilen Yttriumnitrat, 1,5-2,5 Teilen Ölsäure, 1-2 Teilen Schmiermittel, 3-15 Teilen Bindemittel und 10-30 Teilen deionisiertem Wasser zu 100 Teilen Nano-Aluminiumoxidpulver, Geben dieser in eine Mischmaschine und Mischen dieser für 1~5 Stunden bei einer Temperatur unter 30 °C, um so den Aluminiumoxidwabenkeramikschlamm mit gleichmäßiger Verteilung und einem Feststoffgehalt von 75-85 % für die spätere Verwendung herzustellen;
Schritt 2: Formen einer Aluminiumoxidwabenkeramik: Hinzufügen des in Schritt 1 hergestellten Aluminiumoxidwabenkeramikaufschlämmung in eine Keramik-Strangpressmaschine vom Schneckentyp mit einer Vakuumentgasungsvorrichtung und Strangpressen hohler, dünnwandiger Wabenkeramikrohlinge aus der Keramikaufschlämmung durch den Stempelkopf bei Druck durch die Schnecke;
Schritt 3: Trocknen der Aluminiumoxidwabenkeramikrohlinge: Überführen der in Schritt hergestellten Keramikrohlinge in einen Ofen, Trocknen und Dehydrieren dieser für 5 bis 10 Minuten mit 40-50 °C heißer Luft, um so einen Keramikgrünkörper mit zufriedenstellendem Aussehen und zufriedenstellender Geradheit zu erlangen;
Schritt 4: Entbindern des Aluminiumoxidkeramikgrünkörpers: Biskuitbrennen des in Schritt 3 hergestellten Keramikgrünkörpers bei 1100-1200 °C, um eine Biskuitkeramik zu erlangen;
Schritt 5: Brennen der Aluminiumoxidwabenkeramik: Platzieren der in Schritt 4 hergestellten Biskuitkeramik in einem Hochtemperatur-Molybdänrohr und Brennen dieser in einer Wasserstoffatmosphäre oder direkt an der Luft bei 1600-1800 °C, um eine Aluminiumoxidwabenkeramik zu erlangen;
Schritt 6: Herstellung eines gedruckten Heizschaltkreises (2) und eines zugehörigen Drahts (3) an einer Oberfläche der Aluminiumoxidwabenkeramik: Drucken eines dickschichtigen elektrischen Heizdrahts (3) auf die äußere Oberfläche der in Schritt 5 hergestellten Aluminiumoxidwabenkeramik mittels Siebdrucktechnologie, nachdem der gedruckte Schaltkreis (2) getrocknet ist, Auftragen von Silberlot auf einem Bondpad, um den Draht zu befestigen, dann erneutes Trocknen dieser im Ofen und dann Überführen dieser in eine Feuerstätte zum Sintern bei 800-1500 °C, um so einen integral gesinterten Draht und gedruckten Schaltkreis zu erlangen und gleichzeitig Silberlöten des Drahtes in der Feuerstätte abzuschließen.

12. Herstellungsverfahren für das keramische Heizelement nach Anspruch 11, wobei das in Schritt 1 verwendete Nano-Aluminiumoxidpulver eine Reinheit von 99,99 % oder mehr, eine Partikelgröße von 350 nm und eine spezifische Oberfläche von 7 m²/g aufweist.

## Revendications

1. Élément chauffant en céramique, comprenant :
un corps en céramique nid d'abeille (1), dans lequel des canaux poreux (11) sont agencés dans le corps en céramique nid d'abeille (1), et les canaux poreux (11) sont des trous circulaires ou des trous polygonaux ; et
un circuit imprimé chauffant (2), dans lequel le circuit imprimé chauffant (2) est agencé autour de la surface externe du corps en céramique nid d'abeille (1) pour chauffer l'air passant à travers les canaux poreux (11), **caractérisé en ce que** le corps en céramique nid d'abeille (1) est un corps en céramique nid d'abeille alumine (1), le corps en céramique nid d'abeille alumine (1) a une masse volumique qui n'est pas inférieure à 3,86 g/cm³, et les canaux poreux (11) sont uniformément répartis dans le corps en céramique nid d'abeille (1).

2. Élément chauffant en céramique selon la revendication 1, dans lequel les canaux poreux (11) sont agencés au centre du corps en céramique nid d'abeille (1).

3. Élément chauffant en céramique selon l'une quelconque des revendications 1 et 2, dans lequel, le corps en céramique nid d'abeille (1) est un cylindre avec une coupe circulaire ou polygonale.

4. Dispositif de chauffage de tabac chauffé de type chauffage à air, comprenant :
un élément chauffant en céramique selon l'une quelconque des revendications 1 à 3 ;
un dispositif de préchauffage (20), dans lequel l'élément chauffant en céramique est agencé sous le dispositif de préchauffage (20).

5. Dispositif de chauffage de tabac chauffé de type chauffage à air selon la revendication 4, dans lequel le dispositif de préchauffage (20) comprend un tube de préchauffage (21), un déflecteur (22) est agencé entre le tube de préchauffage (21) et l'élément chauffant en céramique, et une pluralité de trous de guidage (31) sont agencés sur le déflecteur (22).

6. Dispositif de chauffage de tabac chauffé de type chauffage à air selon la revendication 4, dans lequel l'élément chauffant en céramique et le dispositif de préchauffage (20) sont agencés dans un manchon d'étanchéité (4).

7. Dispositif de chauffage de tabac chauffé de type chauffage à air selon la revendication 4, dans lequel le dispositif de préchauffage (20) comprend un tube en céramique alumine à paroi mince pour le préchauffage, une cavité (210) au centre du tube en céramique alumine à paroi mince est convenable pour placer le produit à fumer ; une ouverture à une extrémité du tube en céramique alumine à paroi mince et une plaque de base (23) forment un corps de tasse, et une pluralité de trous d'écoulement d'air chaud sont agencés sur la plaque de base (23).

8. Dispositif de chauffage de tabac chauffé de type chauffage à air selon la revendication 7, dans lequel le corps de tube en céramique alumine à paroi mince (1) a une masse volumique non inférieure à 3,86 g/cm³.

9. Dispositif de chauffage de tabac chauffé de type chauffage à air selon la revendication 7, dans lequel une pluralité de trous d'écoulement d'air chaud (32) sont uniformément agencés autour d'un cercle virtuel au centre de la plaque de base (23), et les trous d'écoulement d'air chaud (32) sont des trous circulaires avec un diamètre allant de 0,1 mm à 2 mm.

10. Dispositif de chauffage de tabac chauffé de type chauffage à air selon la revendication 7, dans lequel la plaque de base (23) est faite de céramique alumine de haute pureté.

11. Procédé de préparation de l'élément chauffant en céramique selon l'une quelconque des revendications 1 à 3, le procédé de préparation comprenant les étapes suivantes :
étape 1, préparation d'une barbotine de céramique alumine : ajouter 0,01 à 0,05 partie (en poids) de nitrate de magnésium, de 0,01 à 0,05 partie d'oxychlorure de zirconium, de 0,01 à 0,05 partie de nitrate d'yttrium, de 1,5~2,5 parties d'acide oléique, de 1-2 parties de lubrifiant, de 3-15 parties de liant et de 10~30 parties d'eau désionisée dans 100 parties de nanopoudre d'alumine, les mettre dans une machine de mélange, et les mélanger pendant 1~5 h à une température en dessous de 30 °C, pour préparer ainsi la barbotine de céramique nid d'abeille alumine avec une distribution uniforme et une teneur en extrait sec de 75 à 85 % pour une utilisation ultérieure ;
étape 2 , moulage de la céramique nid d'abeille alumine : ajouter la barbotine de céramique nid d'abeille alumine préparée à l'étape 1 dans une machine de moulage par extrusion de céramique de type à vis équipée d'un dispositif de dégazage sous vide, et extruder des ébauches de céramique nid d'abeille creuses à paroi mince à partir de la barbotine de céramique à travers la tête de filière sous poussée de la vis ;
étape 3, séchage des ébauches de céramique nid d'abeille alumine : transférer les ébauches de céramique préparées à l'étape 2 dans un four, les faire sécher et les déshydrater pendant 5 à 10 minutes sous 40 à 50 °C d'air chaud, pour obtenir ainsi une ébauche crue de céramique avec une apparence et une rectitude satisfaisantes ;
étape 4, déliement de l'ébauche crue de céramique alumine : biscuiter l'ébauche crue de céramique préparée à l'étape 3 à 1100 à 1200 °C pour obtenir une céramique biscuitée ;
étape 5, cuisson de la céramique nid d'abeille alumine : placer la céramique biscuitée préparée à l'étape 4 dans un tube en molybdène à haute température et la cuire sous une atmosphère d'hydrogène ou directement à l'air à 1600 à 1800 °C pour obtenir une céramique nid d'abeille alumine ;
étape 6, préparation d'un circuit imprimé (2) de chauffage de surface en céramique nid d'abeille alumine et de son fil (3) : imprimer un fil chauffant électrique à film épais (3) sur la surface externe de la céramique nid d'abeille alumine préparée à l'étape 5 à l'aide d'une technologie de sérigraphie, après séchage du circuit imprimé (2), appliquer un brasage tendre à l'argent sur une aire de soudure pour coller le fil, les sécher à nouveau au four, puis les transférer dans un fourneau pour un frittage à 800 °C à 1500 °C, pour obtenir ainsi un fil et un circuit imprimé intégralement frittés, et simultanément, achever le brasage tendre à l'argent du fil dans le fourneau.

12. Procédé de préparation de l'élément chauffant en céramique selon la revendication 11, dans lequel la nanopoudre d'alumine utilisée à l'étape 1 a une pureté de 99,99 % ou au-dessus, une taille de particule de 350 nm, et une superficie spécifique de 7 m²/g.
